# EUROPÄISCHE PATENTSCHRIFT

(11) **EP 0 978 577 B1**
(45) Veröffentlichungstag und Bekanntmachung des Hinweises auf die Patenterteilung: **17.12.2003**
(21) Anmeldenummer: 98114849.7
(22) Anmeldetag: 07.08.1998
(51) Int. Cl.: C25F 7/00

(54) **Verfahren und Vorrichtung zum elektrochemischen Bearbeiten von Werkstücken**
Process and apparatus for the electrochemical machining of workpieces
Procédé et dispositif d'usinage électrochimique de pièces

(43) Veröffentlichungstag der Anmeldung: 09.02.2000
(73) Patentinhaber: Frembgen, Fritz-Herbert, D-87700 Memmingen (DE)
(72) Erfinder: Frembgen, Fritz-Herbert, D-87700 Memmingen (DE)
(74) Vertreter: Hübner, Hans-Joachim, Dipl.-Ing.

(56) Entgegenhaltungen:
- WO-A-93/14249
- DE-A- 1 931 174
- GB-A- 1 465 431
- GB-A- 2 203 756

## Beschreibung

Die Erfindung betrifft ein Verfahren zum elektrochemischen Bearbeiten, insbesondere Polieren eines eine Metalloberfläche aufweisenden Werkstückes bei dem das Werkstück eine Anode bildet und ein Werkzeug die Kathode umfasst, das Werkstück relativ zum Werkzeug kontinuierlich bewegt wird und zwischen Werkzeug und Werkstück ein der Kathode und der Anode zugeordneter Arbeitsspalt sowie beidseitig an diesen anschließende, von den Wandungen des Werkzeuges und dem Werkstück. begrenzte Laufspalten gebildet werden, und durch den Arbeitsspalt ein Elektrolytstrom geführt wird, der in einem ersten Bereich des Arbeitsspaltes auf das Werkstück trifft und an mindestens einem zweiten Bereich des Arbeitsspaltes vom Werkstück über das Werkzeug weggeführt wird, wobei in den vom Elektrolytstrom benetzten Bereichen des Arbeitsspaltes an der Oberfläche des Werkstückes die elektrochemische Bearbeitung erfolgt.

Ein derartiges Verfahren ist aus der EP 0 663 461 A1 bekannt. Der Elektrolyt wird durch die Kathode hindurch mittels einer Pumpe in ein Kissen gedrückt, das geringfügig in den Arbeitsspalt vorsteht. Der Außenrand des Kissens grenzt an einen Ringraum des Werkzeuges an, in dem mittels einer Saugpumpe ein Unterdruck erzeugt wird. Die Saugpumpe fördert verbrauchte Elektrolytflüssigkeit in ein Sammelbecken zurück. Das Kissen soll dazu dienen, die Elektrolytbenetzung des Werkstückes zu begrenzen.

Die WO 93/14249 zeigt eine ecm-Vorrichtung. Laut dieser Druckschrift können Luft- und Flüssigkeitsdichtungen den Einlaß und den Auslaß der Kammer bei einem Arbeitsdruck von bis zu 10 bar abdichten. Die Druckschrift befasst sich entgegen dieser Anmeldung mit der Abdichtung des Laufspalts und nicht mit der Begrenzung der Elektrolyaufschlagung im Kathodenbereich.

Bei der US-4,486,279 A wird die Kathode beidseitig unter Bildung einer Strömungskammer von einer Wandung des Werkzeuges umgeben. Der Elektrolyt strömt auf der einen Seite der Kathode in den Arbeitsspalt und verläßt diesen auf der anderen Seite der Kathode. Die beidseitig des Arbeitsspaltes vorhandenen Laufspalten tragen keine Dichtungsmittel, sodaß eine lokale Begrenzung der Bearbeitungszone nicht vorhanden ist.

Aus der EP 0 520 324 A1 ist eine Vorrichtung bekannt, die zwar nicht zum elektrochemischen Bearbeiten sondern zum Ätzen von Leiterplatten dient. Bei dieser wird die Ätzflüssigkeit in einer abgregrenzten Kammer, etwa mittig auf die Leiterplatte gebracht und beidseitig davon wieder abgesaugt. Den Laufspalten sind Abdichtungsmittel in Form von Bürsten oder Walzen zugeordnet.

Beim elektrochemischen Bearbeiten, insbesondere beim Polieren, wird die Oberfläche des Werkstückes abgetragen, wobei auch in die Oberfläche eingepreßte Verunreinigungen entfernt werden. Hydroxid-Niederschläge beim Poliervorgang können Verfärbungen in Abhängigkeit von der jeweiligen Stromdichte bewirken. Niedrigere Stromdichten unter ca. 0,5 A/mm² (in Abhängigkeit von der Materialzusammensetzung) und niedrige Elektrolytströmungsgeschwindigkeiten bewirken diese Verfärbungen. Die Stromdichte ist dort am höchsten, wo die Kathode dem anodischen Werkstück gegenübersteht und hängt von dem Maß der Entfernung ab. An diesen Stellen ist der Poliereffekt am größten. Mit Entfernung von der Kathode nehmen die Stromdichte exponentiell und der Poliereffekt markant ab.Es treten Verfärbungen auf, die sich bei weiterer Entfernung von der Kathode bzw. Abnahme der Stromdichte allmählich verlieren.

Um solche Verfärbungen beim elektrochemischen Polieren zu vermeiden, kommt es auf eine möglichst exakte Begrenzung der Elektrolytbenetzung des Werkstückes im Arbeitsspalt an. Die eingangs beschriebenen bekannten Vorgänge dazu sind für das kontinuierliche Polieren ungeeignet.

Aufgabe der Erfindung ist es, ein Verfahren und eine Vorrichtung bereitzustellen, die eine kontinuierliche Bearbeitung der Oberfläche eines Werkstückes mit beliebiger Geometrie ermöglichen und wobei gleichzeitig das Entstehen von Verfärbungen an der Werkstückoberfläche weitestgehend unterbunden wird.

Diese Aufgabe wird bei einem Verfahren der eingangs genannten Art dadurch gelöst, daß in einem der Bereiche des Arbeitsspaltes mittels eines Fremdfluids im Arbeitsspalt oder im benachbarten Laufspalt eine verschiebbare Barriere für den Elektrolytstrom aufgebaut wird, die in einer Übergangszone zwischen Arbeitsspalt und Laufspalt eine definierte Abrißkante des Elektrolytstromes an der Oberfläche des Werkstückes erzeugt.

Die Erfahrung hat gezeigt, daß das Absaugen von Elektrolyt an den Enden des Arbeitsspaltes nicht ausreicht, den Arbeitsspalt zu begrenzen, nicht einmal, wenn den anschließenden Laufspalten Abdichtungsmittel zugeordnet sind. Dagegen wird dieses Ziel mit dem erfindungsgemäß eingesetzen Fremdfluid erreicht, das im einfachsten Fall ein Druckpolster bildet, das im Bereich des Laufspaltes zur Wirkung kommt und dort eine exakte Abrißkante für den Elektrolytstrom erzeugt. Durch Einstellung des Druckes im Fluidvorrat kann diese Abrißkante an das dem Arbeitsspalt zugewandte Ende des Laufspaltes oder tiefer in den Laufspalt hinein verschoben werden. Daher ist es einfach, die Barriere für den Elektrolytstrom so zu positionieren, daß an dieser Stelle eine noch ausreichende Stromdichte herrscht, sodaß der Poliervorgang ohne jegliche Verfärbungen optimal verläuft.

Anstelle eines Überdruckes im Fluidvorrat kann selbstverständlich auch ein Unterdruck vorgesehen werden, der dann mit dem entsprechenden Druck des Elektrolytstromes korrespondiert.

Die Erfindung betrifft weiterhin eine Vorrichtung Vorrichtung zum elektrochemischen Bearbeiten, insbesondere Polieren eines eine Metalloberfläche aufweisenden Werkstückes, das eine Anode bildet, mit einem, eine Kathode aufweisenden Werkzeug, wobei zwischen Werkstück und Kathode ein Arbeitsspalt gebildet wird und das Werkzeug eine im Arbeitsspalt mündende Zuleitung und eine Ableitung für Elektrolytflüssigkeit sowie diese begrenzende Wandungen aufweist, die je mit dem Werkstück einen, sich an den Arbeitsspalt anschliessenden Laufspalt bilden.

Diese Vorrichtung ist dadurch gekennzeichnet, daß in einem Laufspalt ein Kanal mündet, der an einen Vorrat eines Fremdfluids angeschlossen ist, dessen Druck bezüglich des Druckes der Elektrolytflüssigkeit im Arbeitsspalt einstellbar ist, wobei sich diese Einstellung auf die Position der vom Fremdfluid im Lauf- oder Arbeitsspalt gebildeten Barriere für die Elektrolytflüssigkeit auswirkt.

Weiterbildungen der Erfindung bestehen darin, daß sich auf der vom Arbeitsspalt abgewandten Seite an den Laufspalt eine geschlossene Kammer anschließt, die sich über wenigstens den größten Teil der Bearbeitungsbreite bzw. des Bearbeitungsumfanges des Werkstückes erstreckt, und daß die Kammer das Fremdfluid enthält. In einer bevorzugten Ausführung bildet eine Bodenwand der Kammer mit dem Werkstück eine Laufspaltverlängerung, die am vom Arbeitsspalt abgewandten Ende Abdichtungsmittel gegenüber dem Werkstück aufweist. Diese Abdichtungsmittel können, wie an sich bekannt, aus Bürstenstreifen oder drehbaren Walzen bestehen. Dadurch werden Leckverluste des Fremdfluids gering gehalten. Es versteht sich im übrigen, daß der Vorrat an Fremdfluid pressostatisch auf einem konstanten Wert gehalten wird.

Als Fremdfluid wird vorzugsweise ein gasförmiges Medium, wie Luft oder ein Inertgas verwendet, obwohl es in speziellen Fällen durchaus vorteilhaft sein kann, anstelle des Gases ein flüssiges, insbesondere dickflüssiges Medium zu verwenden, das sich entweder mit der Elektrolytflüssigkeit nicht verbindet oder sich von dieser leicht trennen läßt.

Anhand der Zeichnung, die Ausführungsbeispiele darstellt, wird die Erfindung näher beschrieben.

Es zeigt:

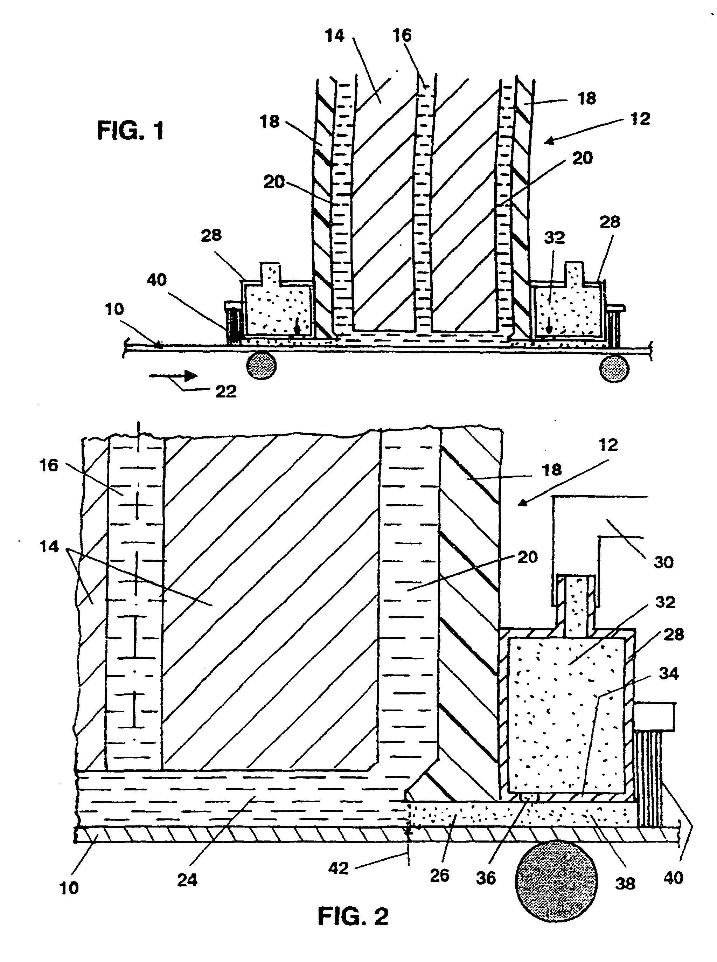

FIG. 1 eine schematische Ansicht einer Vorrichtung zum kontinuierlichen, elektrochemischen Polieren eines metallenen Werkstückes,
FIG. 2 die Ansicht der Vorrichtung gemäß FIG. 1 in größerem Maßstab, und
FIG. 3 die schematische Ansicht einer Vorrichtung zum Polieren runder Gegenstände.

Ein Werkzeug 12 zum elektrochemischen Polieren eines Werkstückes 10 mit Metalloberfläche besitzt eine zentrale Kathode 14, die mit dem Minuspol einer Gleichspannungsquelle verbunden ist. Der Pluspol ist mit dem Werkstück 10 verbunden. Im Inneren der zylindrischen Kathode 14 befindet sich eine Zuleitung 16 für Elektrolytflüssigkeit. Im Abstand beidseitig von der Kathode 14 befinden sich Wandungen 18 beispielsweise aus Kunststoff. Zwischen Kathode 14 und Wandung 18 werden jeweils Ableitungen 20 für den Elektrolyten gebildet.

Das Werkzeug 12 mit Kathode 14 und Wandungen 18 kann kreiszylindrisch, aber auch mit einem Rechteckquerschnitt ausgebildet sein, sodaß seine Längserstreckung senkrecht zur Papierebene verläuft.

Das Werkstück 10 bewegt sich in Richtung des Pfeiles 22 von links nach rechts. Dabei liegt es im Rahmen der Erfindung, das Werkstück 10 fest zu positionieren und dafür das Werkzeug 12 beweglich anzuordnen.

Die Kathode 14 hat einen gewissen Abstand vom Werkstück 10- Durch diesen Abstand wird ein Arbeitsspalt 24 gebildet. In Betrieb strömt der Elektrolyt unter Druck durch die Zuleitung 16 in den Arbeitsspalt 24 und füllt diesen aus und verläßt den Arbeitsspalt durch die Ableitungen 20. Die Wandungen 18 des Werkzeuges 12 überragen die Kathode 14 geringfügig in Richtung des Werkstückes 10, obwohl dies nicht zwingend ist. In jedem Fall wird zwischen jeder Wandung 18 und dem Werkstück 10 ein Laufspalt 26 gebildet, der eine Leckstelle für den Elektrolytstrom darstellt, die beim Polieren zu den unerwünschten Verfärbungen der Oberfläche des Werkstückes 10 führen würde, was zu vermeiden ist.

Bei einem kreiszylindrischen Werkzeug 12 erstreckt sich um die kreiszylindrische Wandung 18 herum eine Kammer 28. Bei einem quaderförmigen Werkstück 10 erstreckt sich die Kammer 28 mit ihrer Längsrichtung senkrecht zur Zeichenebene und sitzt an der bezüglich der Bewegungsrichtung des Werkstückes 10 vom liegenden Wandung 18. Die hintere Wandung 18 bedarf einer solchen Kammer 28 nicht, wenn der dortige Laufspalt auf andere Weise ausreichend abgedichtet werden kann. Im Ausführungsbeispiel ist an beiden Wandungen 18 außenseitig jeweils eine Kammer 28 vorgesehen. In dieser Kammer 28 befindet sich ein Fluid unter Druck, das über eine Versorgungsleitung 30 ergänzt wird. Mittels eines nicht dargestellten Drucksensors und eines Ventils wird ein vorgewählter Druck des Fluids 32 in der Kammer 28 aufrechterhalten. Die Kammer 28 hat in einer Bodenwand 34 einen sich über die ganze Länge der Kammer 28 erstreckenden Kanal 36, der in den Laufspalt 26 mündet. Zwischen der Bodenwand 34, der Kammer 28 und dem Werkstück 10 wird eine Laufspaltverlängerung 38 gebildet, die außenseitig durch ein Dichtungsmittel 40 in Form eines Bürstenstreifens geschlossen ist.

Im Polierbetrieb steht der Elektrolytstrom im Arbeitsspalt 24 unter einem gewissen Überdruck, beispielsweise von 0,5 bar. In der Kammer 28 wird nun der Druck des Fluids 32 auf einen Wert eingestellt, der in erster Annäherung dem Druck im Arbeitsspalt 24 entspricht, jedoch je nach Form des Werkzeuges 12 auch geringfügig größer. oder kleiner sein kann. Im Ausführungsbeispiel ist der Druck des Fluids 32 in der Kammer 28 geringfügig unter 0,5 bar eingestellt, was dazu führt, daß der Elektrolyt geringfügig in den Laufspalt 26 eintritt, wodurch eine geringe Komprimierung des Fluids erfolgt, dieses jedoch eine Barriere 42 gegen das weitere Eindringen des Elektrolyten bildet. An dieser Barriere 42 löst sich der Elektrolyt vom Werkstück 10. Es bildet sich eine definierte Abrißkante, sodaß der Poliervorgang - auf ein stationäres Werkstück 10 bezogen - an dieser Kante endet. Bei bewegtem Werkstück wandert diese Abrißkante entgegen der Bewegungsrichtung an der Werkstückoberfläche nach hinten.

Würde man den Druck in der Kammer 28 etwas höher einstellen als er im Arbeitsspalt 24 herrscht, so würde das Fluid geringfügig in den Arbeitsspalt 24 eintreten und durch die Ableitung 20 mit dem Elektrolyt abgezogen werden. Im Fall eines gasförmigen Fluids 32 würden sich am Eintritt in den Arbeitsspalt 24 Bläschen im Elektrolyten bilden, die durch die Ableitung 20 entweichen. Die Barriere 42 würde aber ebenfalls aufgebaut werden, sodaß sich die Abrißkante lediglich geringfügig entgegen der Bewegungsrichtung des Werkstückes 10 verschiebt.

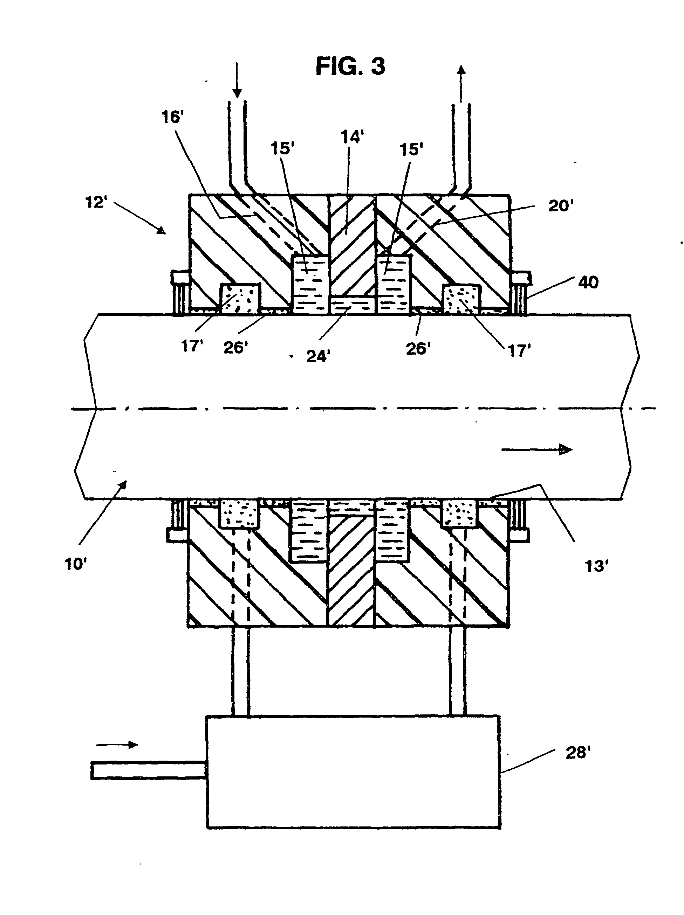

Das Werkzeug 12' gemäß FIG. 3 dient zum elektrochemischen Polieren kreiszylindrischer Werkstücke 10'. Das Werkzeug 12' hat einen kreiszylindrischen Durchgang 13', dessen Durchmesser geringfügig größer als der Außendurchmesser des Werkstückes 10' ist. In der Mittelebene des Werkzeuges 12' befindet sich eine Ringkathode 14', die mit dem Werkstück 10' einen Arbeitsspalt 24' bildet. Beidseitig der Kathode 14' befinden sich im Werkzeug 12' Ringnuten 15', in deren eine eine Zuleitung 16' und in deren andere eine Ableitung 20' münden. Durch die Zuleitung 16' wird Elektrolytflüssigkeit in der durch die Ringnut 15' gebildeten Ringkammer umfangsmäßig verteilt, strömt dann axial durch den Arbeitsspalt 24' und verläßt die andere Ringkammer durch die Ableitung 20'.

Auf den vom Arbeitsspalt 24' abgewandten Seiten jeder Ringnut 15' befindet sich in einem Axialabstand jeweils eine weitere Ringnut 17', die mittels Bohrungen an die Kammer 28' angeschlossen sind, welche den Vorrat an Fluid enthält. Im Betrieb wird wiederum der Druck des Fremdfluids in jeder Ringnut 17' auf den Druck des Elektrolyten in den Ringnuten 15' so abgestimmt, daß in den Laufspalten 26' Barrieren gegen das Eindringen von Elektrolyt gebildet werden, die an der Umfangsfläche des Werkstückes 10' definierte Abrißkanten bilden.

## Patentansprüche

1. Vorrichtung zum elektrochemischen Bearbeiten, insbesondere Polieren eines eine Metalloberftäche aufweisenden Werkstückes (10, 10'), das eine Anode bildet, mit einem, eine Kathode (14, 14') aufweisenden Werkzeug (12, 12'), wobei zwischen Werkstück (10, 10') und Kathode (14, 14') ein Arbeitsspalt (24, 24') gebildet wird und das Werkzeug (12, 12') eine im Arbeitsspalt(24,24') mündende Zuleitung (16, 16') und eine Ableitung (20, 20') für Elektrolytflüssigkeit sowie diese begrenzende Wandungen (18) aufweist, die je mit dem Werkstück (10, 10') einen, sich an den Arbeitsspalt (24, 24') anschliessenden Laufspalt (26, 26') bilden, **dadurch gekennzeichnet, daß** in einem Laufspalt (26, 26') ein Kanal (36) mündet, der an einen Vorrat eines Fremdfluids (32) angeschlossen ist, dessen Druck bezüglich des Druckes der Elektrolytflüssigkeit im Arbeitsspalt (24, 24') einstellbar ist, wobei sich diese Einstellung auf die Position der vom Fremdfluid (32) im Lauf- oder Arbeitsspalt gebildeten Barriere (42) für die Elektrolytflüssigkeit auswirkt.

2. Vorrichtung nach Anspruch 1, **dadurch gekennzeichnet, daß** sich auf der vom Arbeitsspalt (24, 24') abgewandten Seite an den Laufspalt (26, 26') eine geschlossene Kammer (28, 28') anschließt die sich über wenigstens den größten Teil der Bearbeitungsbreite oder des Bearbeitungsumfanges des Werkstückes (10, 10') erdtreckt, und daß die Kammer (28, 28') das Fremdfluid (32) enthält.

3. Vorrichtung nach Anspruch 2, **dadurch gekennzeichnet, daß** eine Bodenwand (34) der Kammer (28) mit dem Werkstück (10) eine Laufspaltverlängerung (38) bildet, die am vom Arbeitsspalt (24) abgewandten Ende Abdichtungsmittel (40) gegenüber dem Werkstück (10) aufweist.

4. Vorrichtung nach einem der Ansprüche 1 bis 3, **dadurch gekennzeichnet, daß** der Vorrat an Fremdfluid (32) ein Druckluftpolster bildet.

5. Vorrichtung nach einem der Ansprüche 1 bis 4, **dadurch gekennzeichnet, daß** das Fremdfluid (32) aus einer Flüssigkeit besteht, die sich mit dem Elektrolyten nicht mischt oder sich von diesem leicht trennen läßt.

6. Verfahren zum elektrochemischen Bearbeiten, insbesondere Polieren eines eine Metalloberfläche aufweisenden Werkstückes (10, 10'). bei dem das Werkstück (10, 10') eine Anode bildet und ein Werkzeug (12, 12') die Kathode (14, 14') umfasst, das Werkstück (10, 10') relativ zum Werkzeug (12, 12') kontinuierlich bewegt wird und zwischen Werkzeug (12, 12') und Werkstück (10, 10') ein der Kathode (14, 14') und der Anode zugeordneter Arbeitsspalt (24, 24') sowie beidseitig an diesen anschließende, von den Wandungen (18,18') des Werkzeuges (12,12') und dem Werkstück (10,10`) begrenzte Laufspalten (26) gebildet werden, und durch den Arbeitsspalt (24, 24') ein Elektrolytstrom geführt wird, der in einem ersten Bereich des Arbeitsspaltes (24; 24') auf das Werkstück (10, 10') trifft und an mindestens einem zweiten Bereich des Arbeitsspaltes (24, 24') vom Werkstück (10, 10') über das Werkzeug (12, 12') weggeführt wird, wobei in den vom Elektrolytstrom benetzten Bereichen des Arbeitsspaltes (24, 24') an der Oberfläche des Werkstückes (10, 10') die elektrochemische Bearbeitung erfolgt, **dadurch gekennzeichnet, daß** in einem der Bereiche des Arbeitsspaltes (24, 24') mittels eines Fremdfluids (32) im Arbeitsspalt (24, 24') oder im benachbarten Laufspalt (26) eine verschiebbare Barriere (42) für den Elektrolytstrom aufgebaut wird, die in einer Übergangszone zwischen Arbeitsspalt (24, 24') und Laufspalt (26) eine definierte Abrißkante des Elektrolytstromes an der Oberfläche des Werkstückes (10, 10') erzeugt.

7. Verfahren nach Anspruch 6, **dadurch gekennzeichnet, daß** die Position der Abrißkante des Elektrolytstromes durch Wahl der Druckdifferenz zwischen dem Druck des Elektrolytstromes im Arbeitsspalt (24, 24') und dem Druck des Fremdfluids (32) eingestellt wird.

8. Verfahren nach Anspruch 6 oder 7, **dadurch gekennzeichnet, daß** das Fremdfluid (32) gasförmig ist.

9. Verfahren nach einem der Ansprüche 6 bis 8, **dadurch gekennzeichnet, daß** das Fremdfluid (32) unter einem Druck oberhalb des Atmosphärendruckes gehalten wird.

## Claims

1. A device for electrochemically processing, in particular polishing, a metal-surfaced tool (10, 10') that forms an anode, with a tool (12, 12') having a cathode (14, 14'), wherein a working gap (24, 24') is established between the tool (10, 10') and cathode (14, 14'), and tool (12, 12') has a feed line (16, 16') and discharge line (20, 20') for electrolyte fluid, and is also bordered by walls (18) which, each along with the tool (10, 10'), form a running gap (26, 26') adjacent to the working gap (24, 24'),
**characterized in that**
a channel (36) empties into an air gap (26, 26'), and is hooked up to a supply of outside fluid (32) whose pressure can be adjusted relative to the pressure of the electrolyte liquid in the working gap (24, 24'), wherein this adjustment affects the position of the barrier (42) for the electrolyte liquid formed by the outside fluid (32) in the running or working gap.

2. The device according to claim 1, **characterized in that** a sealed chamber (28, 28') abuts the air gap (26, 26') on the side facing away from the working gap (24, 24'), extending over at least the majority of the processing width or processing circumference of the tool (10, 10'), and that the chamber (28, 28') contains the outside fluid (32).

3. The device according to claim 2, **characterized in that** a floor wall (34) of the chamber (28) combines with the tool (10) to form an air gap extension (38) that has sealing means (40) relative to the tool (10) on the end facing away from the working gap (24).

4. The device according to one of claims 1 to 3, **characterized in that** the supply of outside fluid (32) forms a compressed air blanket.

5. The device according to one of claims 1 to 4, **characterized in that** the outside fluid (32) consists of a liquid that does not mix with or can easily be separated from the electrolyte.

6. A method for electrochemically processing, in particular polishing, a metal-surfaced tool (10, 10'), in which the tool (10, 10') forms an anode and a tool (12, 12') encompasses a cathode (14, 14'), tool (10, 10') is moved continuously relative to tool (12, 12'), and a working gap (24, 24') allocated to the cathode (14, 14') and anode is formed between tool (12, 12') and tool (10, 10'), along with bilaterally abutting running gaps (26) bounded by the walls (18, 18') of tool (12, 12') and tool (10, 10'), and an electrolyte stream is guided through working gap (24, 24'), hitting tool (10, 10') in a first area of working gap (24, 24') and being routed away from tool (10, 10') via tool (12, 12') at least at a second area of the working gap (24, 24'), wherein electrolytic processing takes place in the areas of working gap (24, 24') wetted by the electrolyte stream on the surface of tool (10, 10'),
**characterized in that**
a movable barrier (42) for the electrolyte stream is built up in one of the areas of working gap (24, 24') using an outside fluid (32) in working gap (24, 24') or in the adjacent air gap (26), generating a defined tear-off edge of the electrolyte stream on the surface of tool (10, 10').

7. The method according to claim 6, **characterized in that** the position of the tear-off edge of the electrolyte stream is set by selecting the pressure differential between the pressure of the electrolyte stream in working gap (24, 24') and the pressure of outside fluid (32).

8. The method according to claim 6 or 7, **characterized in that** the outside fluid (32) is gaseous.

9. The method according to one of claims 6 to 8, **characterized in that** the outside fluid (32) is kept under a pressure exceeding atmospheric pressure.

## Revendications

1. Dispositif pour le traitement électrochimique, en particulier pour le polissage d'une pièce (10,10') présentant une surface métallique et constituant une anode, avec un outillage (12,12') présentant une cathode (14,14'), du type selon lequel un interstice ou compartiment de travail (24,24') est ménagé entre la pièce (10,10') et la cathode (14,14') et selon lequel l'outillage (12,12') présente un conduit d'amenée (16,16') débouchant dans l'interstice de travail (24,24'), un conduit d'évacuation (20,20') pour l'électrolyte, ainsi que les parois (18) délimitant la localisation dudit électrolyte, chacune desdites parois constituant avec la pièce (10,10') un interstice de circulation (26,26') contigu audit interstice de travail (24,24'),
**caractérisé en ce**
**qu'**un canal (36) débouche dans un interstice de circulation (26,26') et est contigu à une réserve d'un fluide étranger (32), dont la pression par rapport à la pression de l'électrolyte dans l'interstice de travail (24,24') est réglable, le réglage ayant une incidence sur la position de la barrière (42), vis-à-vis de l'électrolyte, formée par le fluide étranger (32) dans l'un desdits interstices de circulation ou de travail.

2. Dispositif selon la revendication 1, **caractérisé en ce qu'**une chambre fermée (28,28') est contiguë à l'interstice de circulation (26,26') du côté éloigné de l'interstice de travail (24,24'), ladite chambre s'étendant sur au moins la plus grande partie de la largeur ou de la circonférence de la zone de la pièce (10,10') à traiter, et **en ce que** la chambre (28,28') renferme le fluide étranger (32).

3. Dispositif selon la revendication 2, **caractérisé en ce qu'**une paroi inférieure (34) de la chambre (28) forme avec la pièce (10) un prolongement (38) de l'interstice de circulation, qui présente des moyens d'étanchéité (40) à l'extrémité éloignée de l'interstice de travail (24), disposés contre la pièce (10).

4. Dispositif selon l'une des revendications 1 à 3, **caractérisé en ce** la réserve en fluide (32) constitue un coussin d'air comprimé.

5. Dispositif selon l'une des revendications 1 à 4, **caractérisé en ce que** le fluide étranger (32) se compose d'un liquide non miscible avec l'électrolyte ou susceptible d'être séparé de celui- ci.

6. Procédé pour le traitement électrochimique, en particulier pour le polissage d'une pièce (10,10') présentant une surface métallique, du type selon lequel la pièce (10,10') constitue une anode tandis qu'un outillage (12,12') comprend la cathode (14,14'), du type selon lequel la pièce (10,10') est déplacée de façon continue par rapport à l'outillage (12,12') tandis qu'entre l'outillage (12,12') et la pièce (10,10'), un interstice de travail (24,24'), associé à la cathode (14,14') et à l'anode, de même que, selon une disposition contiguë audit interstice de travail et de part et d'autre de celui- ci, des interstices de circulation (26), délimités par les parois (18,18') de l'outillage (12,12') et par la pièce (10,10'), sont formés, et du type selon lequel, à travers l'interstice de travail (24,24'), on fait passer un courant électrolytique, qui rencontre la pièce (10,10') dans une première zone de l'interstice de travail (24,24') et s'éloigne de la pièce (10,10') via l'outillage (12,12') dans au moins une seconde zone de l'interstice de travail (24,24'), avec réalisation du traitement électrolytique à la surface de la pièce (10,10') dans les zones de l'interstice de travail (24,24') parcourues par ledit courant électrolytique,
**caractérisé en ce que**,
dans l'une des zones de l'interstice de travail (24,24') au moyen d'un fluide étranger (32) ou dans l'interstice de circulation (26) voisin, une barrière mobile (42) pour le courant électrolytique est ménagée, ladite barrière engendrant, dans une zone de passage entre les interstices de travail (24,24') et de circulation (26), une arête définie de rupture ou de discontinuité du courant électrolytique à la surface de la pièce (10,10').

7. Procédé selon la revendication 6, **caractérisé en ce que** la position de ladite arête de rupture du courant électrolytique est réglée par le choix de la différence de pression entre la pression du courant électrolytique dans l'interstice de travail (24,24') et la pression du fluide étranger (32).

8. Procédé selon la revendication 6 ou 7, **caractérisé en ce que** le fluide étranger (32) est à l'état gazeux.

9. Procédé selon l'une des revendications 6 à 8, **caractérisé en ce que** le fluide étranger (32) est maintenu sous une pression supérieure à la pression atmosphérique.
